Europäisches Patentamt

European Patent Office

Office européen des brevets

(11) Veröffentlichungsnummer: **0 050 292**
**A1**

(12) # EUROPÄISCHE PATENTANMELDUNG

(21) Anmeldenummer: **81108221.3**

(22) Anmeldetag: **12.10.81**

(51) Int. Cl.³: **G 01 R 31/28**, G 06 F 15/46

(30) Priorität: **16.10.80 DE 3039067**

(43) Veröffentlichungstag der Anmeldung: **28.04.82**
**Patentblatt 82/17**

(84) Benannte Vertragsstaaten: **CH FR GB LI**

(71) Anmelder: **Licentia Patent-Verwaltungs-GmbH,**
**Theodor-Stern-Kai 1, D-6000 Frankfurt/Main 70 (DE)**

(72) Erfinder: **Pagel, Hans, Steinheimer Strasse 91,**
**D-6453 Seligenstadt (DE)**
Erfinder: **Kerkenkamp, Hans Otto, Königsberger**
**Strasse 139, D-6452 Hainburg (DE)**
Erfinder: **Rudolph, Klaus, Speyer-Strasse 9,**
**D-6050 Offenbach/Main (DE)**

(74) Vertreter: **Lertes, Kurt, Dr. et al, Licentia**
**Patent-Verwaltungs-GmbH Theodor-Stern-Kai 1,**
**D-6000 Frankfurt/M 70 (DE)**

(54) **Verfahren zur Prüfung von gedruckten Schaltungsplatinen.**

(57) Ein Verfahren zur Prüfung von gedruckten Schaltungsplatinen wird mittels einer die Schaltungsplatinen enthaltenden Teststation und einer an diese angeschlossenen
Datenverarbeitungsanlage ausgeführt. Der Teststation werden Testsignale in einer durch ein Prüfungsprogramm vorgegebenen Reihenfolge zugeführt. Die Ausgangssignale
der Schaltungsplatinen werden mit vorgegebenen Signalen
verglichen. Den Anschlußstellen der zu prüfenden Schaltungsplatinen sind frei wählbare Adressen zugeordnet.
Die Adressen der für die Prüfung ausgewählten Anschlußstellen werden über ein Sichtgerät eingegeben. Die
Adressen und Prüfanweisungen werden auf einen Sichtschirm in Form einer Tabelle angezeigt. Nach der Eingabe
einer Adresse und von Prüfdaten wird automatisch auf den
nächsten Tabellenplatz umgeschaltet. Die Prüfdaten werden als digitale Zahlen für Pegelbereiche und als Prüfanweisungen für die Art der auszuführenden Prüfung eingegeben.

L i c e n t i a

Patent-Verwaltungs-GmbH

6000 Frankfurt/Main 70, Theodor-Stern-Kai 1

P 30 39 067.1
F 79/54
7. 0.1981
Eb/pae

## Verfahren zur Prüfung von gedruckten Schaltungsplatinen

Die Erfindung bezieht sich auf ein Verfahren zur Prüfung von gedruckten Schaltungsplatinen mittels einer Datenverarbeitungsanlage, die mit einer die jeweilige Schaltungsplatine enthaltenden Teststation verbunden ist, der Testsignale in einer durch ein Prüfprogramm vorgegebenen Reihenfolge zugeführt werden und die mit einer Einrichtung zum Vergleich von Ausgangssignalen mit vorgegebenen Eingangssignalen verbunden ist, wobei diese Einrichtung von der Datenverarbeitungsanlage gesteuert wird und wobei den Anschlußstellen der jeweils zu prüfenden Schaltungsplatine und frei wählbaren Stellen auf der Schaltungsplatine Adressen zugeordnet werden.

Mit integrierten Schaltkreisen lassen sich auf einzelnen gedruckten Schaltungsplatinen komplexe elektrische Funktionen verwirklichen. Daraus ergibt sich zugleich eine erhöhte Fehlerwahrscheinlichkeit. Die Schaltungsplatinen müssen daher auf Fehler untersucht werden. Hierzu dienen Prüfverfahren, durch die die Herstellungskosten der Schaltungsplatinen erhöht werden.

Der Erfindung liegt die Aufgabe zugrunde, ein Prüfverfahren eingangs erläuterten Gattung derart weiterzuentwickeln, daß eine schnelle und einfache Eingabe von Prüfanweisungen und eine leichte Änderung bereits in die Datenverarbeitungsanlage eingegebener Prüfanweisungen möglich ist.

Die Aufgabe wird erfindungsgemäß dadurch gelöst, daß die Adressen der für die Prüfung ausgewählten Anschlußstellen jeweils über die Tastatur eines Sichtgerätes unter automatischer Weiterschaltung auf den benachbarten, einer Adresse zugeordneten freien Platz oder unter Anwahl eines freien Platzes in Zeilen einer festgelegten Tabelle eingegeben werden, die auf dem Schirm des Sichtgerätes angezeigt wird, daß nach der Adresseneingabe in weitere Zeilen der Tabelle jeweils Pegelbereiche durch digitale Zahlen nacheinander unter automatischer Weiterschaltung auf die Adressen zugeordneten Spalten oder beliebig wählbaren Spalten eingegeben werden und daß in spaltenmäßiger Zuordnung zu den Adressen nacheinander unter automatischer Weiterschaltung auf die jeweils benachbarte Spalte Prüfanweisungen eingegeben werden, die sich auf die Art der für eine Anschlußstelle ausgewählten Prüfung beziehen. Die Zuordnung der eingegebenen Daten ist bei diesem Verfahren fest vorgegeben. Die Reihenfolge der zu prüfenden Stellen und die Art der Prüfung kann beliebig sein. Die eingegebenen Prüfanweisungen lassen sich übersichtlich kontrollieren. Zusätzliche Angaben über die Art der eingegebenen Daten sind nicht notwendig. Besonders vorteilhaft ist das vorstehend erläuterte Verfahren, wenn öfters unterschiedlich bestückte Schaltungsplatinen geprüft werden sollen, da eine schnelle Umstellung auf eine andere Prüffolge möglich ist.

Bei einer zweckmäßigen Ausführungsform ist vorgesehen, daß nach der Auswahl der Tabelle vor jeder Adressen-, Pegelbereichs- oder Prüfanweisungseingabe der Cursor des Sichtgerätes unter die jeweilige für die Eingabe vorbereitete, auf dem Sichtgerät durch einen Tabellenplatz festgelegte Stelle springt. Es kann daher sofort festgestellt werden, wann die Datenverarbeitungsanlage für die Eingabe einer weiteren Prüfanweisung zur Verfügung steht und an welcher Stelle der Tabelle die nächste Eingabe erfolgen soll.

Eine günstige Ausführungsform besteht darin, daß durch die Eingabe von Sonderzeichen in Verbindung mit einer eine erste und eine zweite Zeile auswählenden Zahl der Bereich zwischen den Zeilen aus der Tabelle gelöscht wird. Mit dieser Maßnahme lassen sich bereits eingegebene Prüfanweisungen schnell löschen. Die Maßnahme läßt sich vorteilhafterweise auch bei Spalten anwenden, indem durch Eingabe von Sonderzeichen in Verbindung mit einer eine erste und eine zweite Spalte auswählenden Zahl der Bereich zwischen den Spalten aus der Tabelle gelöscht wird. Bei einer bevorzugten Ausführungsform ist vorgesehen, daß durch Eingabe weiterer Sonderzeichen in Verbindung mit einer ersten und einer zweiten Zeile sowie einer Zielzeile der zwischen der ersten und zweiten Zeile liegende Tabellenteil in den auf die Zielzeile folgenden Bereich übernommen wird. Damit können bereits vorhandene Testabläufe in Verbindung mit neu einzugebenden Prüfanweisungen zu einem Prüfablauf zusammengestellt werden. Da bereits vorhandene Prüfanweisungen nicht erneut eingegeben werden müssen, wird die Eingabezeit kürzer. Bei Spalten kann dieses Verfahren ebenfalls angewendet werden, indem durch Eingabe zusätzlicher Sonderzeichen in Verbindung mit einer ersten und einer zweiten Spalte sowie einer Zielspalte der zwischen der ersten und zweiten Spalte liegende Tabellenteil in den auf die Zielspalte folgenden Bereich übernommen wird.

Vorzugsweise wird durch eine zusätzliche Prüfanweisung in Verbindung mit einer Adresse der in einer ersten Betriebsart an dem der Adresse zugeordneten Anschluß vorhandene Pegel gemessen und als Sollpegel für eine zweite Betriebsart gespeichert, in der dieser Sollpegel mit dem Pegel am Anschluß verglichen wird.

Mit dieser Maßnahme kann die Erstellung eines Prüfablaufs erleichtert werden. Es lassen sich nämlich die Eingabedaten an die zu prüfende Schaltplatine legen und die Ausgabedaten als Sollwerte für die weitere Prüfung übernehmen. Voraussetzung hierfür ist, daß die für die Sollwerterzeugung benutzte Schaltungsplatine fehlerfrei ist. Eventuell vorhandene Fehler können aus der angezeigten Tabelle mit einer Solltabelle verglichen und entsprechend korrigiert werden.

Bei einer zweckmäßigen Ausführungsform sind zusätzliche Prüfanweisungen für durch Anschlußadapter herstellbare Diagnoseanschlüsse vorgesehen, denen gesonderte Adressen zugeordnet sind. Damit können logische Zustände auf Schaltungsplatinen an Stellen erfaßt werden, die nicht durch Steckeranschlüsse und die diesen zugeordneten Adressen erreichbar sind. Derartige Prüfungen können im Rahmen der Tabellenkapazität in beliebiger Menge und in beliebigen Spalten vorgesehen werden. Die Verbindung zu den Stellen der Leiterplatine wird mit Adaptern hergestellt.

Vorteilhafterweise wird die Anzahl der an den Anschlußstellen auftretenden Flankenwechsel der binären Signale mit einem vorgegebenen Sollwert verglichen. Mit dieser Maßnahme lassen sich undefinierte Bereiche des Signalverlaufs bei der Prüfung ausblenden.

Die Erfindung wird im folgenden anhand eines in einer Zeichnung dargestellten Ausführungsbeispiels näher erläutert, aus dem sich weitere Merkmale sowie Vorteile ergeben.

Es zeigen
Fig. 1 ein schematisches Schaltbild einer Testanlage,
Fig. 2 einen Bildschirm der in Fig. 1 dargestellten Testanlage in teilweiser Ansicht.

Die Zeichnung zeigt in schematischer Darstellung ein Testsystem, das eine Datenverarbeitungsanlage 1, eine Teststation 2 und ein Sichtgerät 3 mit einer Tastatur 4 aufweist. In der Teststation 2 befindet sich eine zu prüfende Schaltungsplatine 5. Die Teststation 2 hat eine Reihe von Prüflingsanschlüssen und Geräteanschlüsse.

Mit dem Testsystem werden die auf der Schaltungsplatine angeordneten digitalen Schaltkreise automatisch geprüft. Zur Steuerung der automatischen Prüfung dient ein Prüfprogramm, das aus einer Reihe von Prüfanweisungen besteht. Diese Prüfanweisungen werden über das Sichtgerät 3 in die Datenverarbeitungsanlage 1 eingegeben. Für die Eingabe ist die Tastatur 4 bestimmt. In der Teststation 2 ist ein nicht näher dargestellter Komparator zum Vergleich von Ausgangssignalen mit vorgegebenen Eingangssignalen, d. h. Sollwertsignalen, vorhanden. Der Komparator wird von der digitalen Datenverarbeitungsanlage 1 gesteuert. Den Prüflingsanschlüssen sind Adressen zugeordnet. Weiterhin sind für eine Anzahl von wählbaren Stellen auf der Schaltungsplatine 5 zusätzliche Adressen reserviert.

Eine Prüfanweisung setzt sich aus einer Adresse und einem Datenwort zusammen. Die Eingabe der Prüfanweisungen erfolgt in einer bestimmten Betriebsart der Datenverarbeitungsanlage 1. Für die Eingabe kann sich die Datenverarbeitungsanlage beispielsweise in der Betriebsart "Grundstellung" befinden.

Für die Eingabe von Prüfanweisungen arbeitet die Datenverarbeitungsanlage 1 mit dem Sichtgerät 3 und der Tastatur 4 nach dem folgenden Verfahren zusammen. Die Datenverarbeitungsanlage muß eine Anforderung ausgeben, die auf dem Schirm 6 des Sichtgerätes 3 durch ein besonderes Zeichen, z.B. ":" sichtbar ist. Auf diese Anforderung hin wird eine Taste 7 der Tastatur 4 betätigt, um der Datenverarbeitungsanlage mitzuteilen, daß eine Eingabe von Prüfanweisungen erfolgen soll. Die Betätigung der Taste 7 wird von der Datenverarbeitungsanlage 1 dahingehend ausgewertet, daß die Prüfanweisungen in Tabellenstruktur eingegeben werden. Die Datenverarbeitungsanlage 1 veranlaßt danach das Sichtgerät 3, auf dem Schirm 6 einen Tabellenkopf aufzuzeichnen. In dieser Tabelle sind in der ersten Zeile nebeneinander Dezimalzahlen einschreibbar, denen Sollprüfpegel zugeordnet sind. In den weiteren Zeilen schließen sich je Spalte Adressen der Prüflingseingänge an, die mit den Sollprüfpegeln beaufschlagt werden sollen. In den darunter liegenden Zeilen wird die Art der Prüfung durch ein entsprechendes Zeichen vorgegeben. Es kann sich z. B. um eine Treiber- oder Sensoranweisung oder eine Anweisung für Einzel- und Mehrfachimpulse handeln.

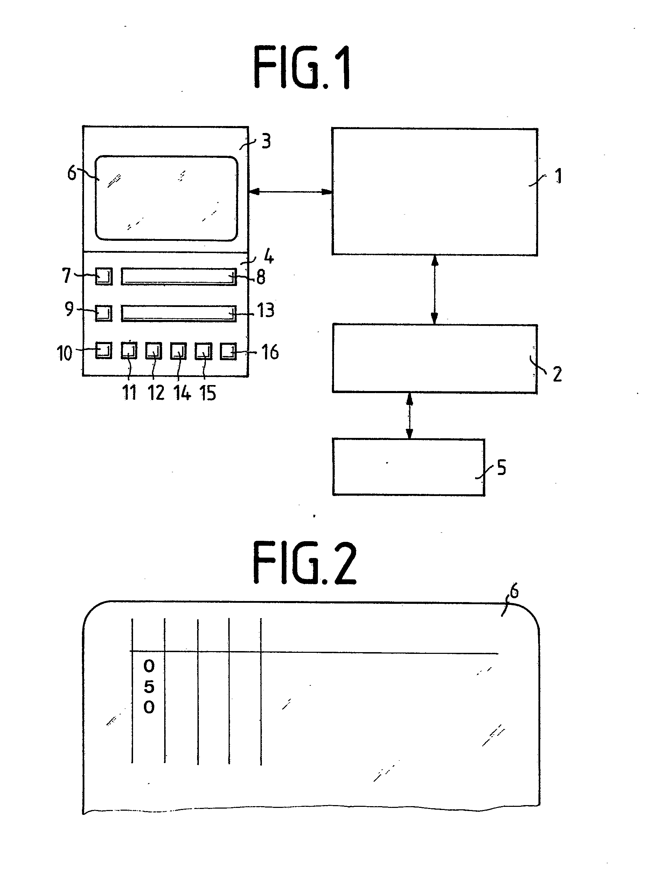

Nach der Anwahl des Tabellenkopfes durch Betätigung der Taste 7 bewegt die Datenverarbeitungsanlage 1 einen Cursor auf den Anfang der zweiten Tabellenzeile, der ein bestimmter Stellenwert, z. B. die Hundertstelle, zugeordnet ist. Durch Blinken des Cursors wird angezeigt, daß die Anlage für die Eingabe von Adressen bereit ist. Die Eingabe der Adresse erfolgt über einen Teil 8 des Tastenfeldes 4, der Eingabetasten für dezimale Ziffern hat. Nach Beendigung der Adresseneingabe ist eine Taste 9 zu betätigen. Über die Taste 9 wird der Datenverarbeitungsanlage 1 signalisiert, daß eine vollständige Adresse eingegeben wurde. Auf dem Schirm 7 wird die gerade eingegebene Adresse, z.B. die Adresse 50, angezeigt. Hierzu werden in einer Spalte liegende Stellen dreier benachbarter Zeilen benötigt. Dies ist in Figur 2 dargestellt.

Nach Eingabe einer vollständigen Adresse und deren Anzeige auf dem Schirm 3 bewegt sich der Cursor, von der Datenverarbeitungsanlage 1 gesteuert, automatisch zur nächstfolgenden Stelle, der in der Tabelle eine Adresse zugeordnet ist. Danach kann auf die oben beschriebene Weise eine neue Adresse eingegeben werden.

Die Stellung des Cursors läßt sich längs der Zeilen durch Betätigung einer für die Linksverschiebung vorgesehenen Taste 10 und einer für die Rechtsverschiebung vorgesehenen Taste 11 wahlweise verändern. Bei der Veränderung der Position des Cursors wird dies von der Datenverarbeitungsanlage überwacht. Die Datenverarbeitungsanlage erfaßt dabei die Stellung des Cursors und die Zuordnung dieser Stelle zu den Zeilen und Spalten der Tabelle. Wenn an einer durch Betätigung der Tasten 10 bzw. 11 ausgewählten Tabellenstelle eine Adresse eingegeben wird, zeigt der Schirm 3 den Eingabewert ebenfalls an. Der Cursor bewegt sich anschließend auf die benachbarte Tabellenstelle.

Die Eingabe des Sollpegelbereichs erfolgt durch Betätigung einer weiteren Taste 11 und einer einem entsprechenden Dezimalwert zugeordneten Taste des Teils 8. Es können mehrere Pegelbereiche für die Überwachung vorgesehen sein, wobei jedem Bereich eine Ziffer zugeordnet ist. Bei Betätigung der Taste 11 wird der Cursor in die oberste Zeile der Tabelle bewegt und blinkt auf der gerade eingestellten Adressenposition. Durch Betätigung der Tasten 10 und 11 läßt sich der Cursor auf beliebige Adressenplätze verschieben. Danach wird eine dem gewünschten Pegelbereich zugeordnete Dezimalzahl über den Teil 8 des Tastenfeldes 4 eingegeben. Die eingegebene Ziffer wird auf dem Schirm 3 angezeigt, während der Cursor automatisch auf die benachbarte Stelle in der obersten Zeile übergeht. Durch eine andere Taste 12 kann der Datenverarbeitungsanlage signalisiert werden, daß keine weitere Pegelbereichseingabe mehr gewünscht wird. Daraufhin geht die Anlage selbsttätig in die oben erläuterte Betriebsweise über, in der die Adresseneingabe angefordert wird.

Über einen weiteren Teil 13 des Tastenfeldes 4 werden die zu einer Adresse benötigten Anweisungen über die Art der an der ausgewählten Stelle durchzuführenden Prüfungen eingegeben. Es kann sich um Treiber- oder Sensoranweisungen handeln, d.h. die der Adresse zugeordnete Stelle am Prüfling wird mit einer durch den Pegelbereich bestimmten Adresse beaufschlagt oder es wird überwacht, ob an der Stelle der vorgegebene Pegelbereich nicht über- oder unterschritten wird. Neben den Treiber- oder Sensoranweisungen für die Pegel von binären Signalen sind auch Anweisungen für die Erzeugung eines Einzelimpulses oder von Mehrfachimpulsen möglich.

Es können auch logische Zustände auf der Schaltungsplatine 2 festgestellt werden, die nicht durch Anschlüsse an der Schaltungsplatine über fest zugeordnete Adressen erfaßbar sind. Hierfür ist eine fest vorgegebene Adresse, z. B. 156, vorgesehen, die in die Tabelle eingefügt werden kann. Für eine solche Prüfanweisung ist eine besondere, nicht näher dargestellte Taste im Teil 13 vorhanden. Der Übergang von einer Tabelle nach deren Fertigstellung auf die nächste kann durch Betätigung einer anderen Taste des Teils 13 erfolgen.

In der Tabelle können auch wahlweise bereits eingegebene Werte wieder gelöscht werden. Hierfür sind als Sonderzeichen "+" und "-" vorgesehen, für die nicht näher dargestellte Tasten im Teil 13 vorhanden sind. Durch Betätigung der Tasten 9 bzw. 10 wird der Cursor auf eine ausgewählte Spalte eingestellt. Danach wird das Zeichen "+" in Verbindung mit einer Zeilennummer eingegeben. Die Datenverarbeitungsanlage fordert danach selbsttätige Eingabe eines weiteren Wertes an. Es wird dann das Zeichen "-" zusammen mit einer Zeilennummer eingegeben. Dies veranlaßt die Datenverarbeitungsanlage dazu, die Daten zwischen den beiden angegebenen Zeilennummern zu löschen.

Die Löschung von Spaltenbereichen ist ebenfalls möglich. Der Cursor wird hierfür auf die ausgewählte Zeile eingestellt. Danach wird die Spaltennummer angegeben, ab der die Löschung erfolgen soll. Anschließend wird die Spaltennummer mitgeteilt, die das Ende des Spaltenbereichs für die Löschung bestimmt.

Auf dem Tastenfeld 4 ist eine weitere Taste 14 für die Auswahl von Tabellenbereichen vorhanden. Die Betätigung der Taste 14 signalisiert der Datenverarbeitungsanlage 1, daß ein Tabellenbereich kopiert werden soll. Anschließend wird mit einem "+"-Zeichen und einer Zeilennummer der Beginn des zu kopierenden Bereichs und mit einem "-"-Zeichen in Verbindung mit einer Zeilennummer das Ende eines zu kopierenden Bereichs angegeben. Mittels Betätigung einer anderen Taste 15 wird der Datenverarbeitungsanlage gemeldet, daß sich die anschließend eingegebenen Daten auf die Zeile beziehen, ab der der zu kopierende Bereich in aufsteigender Reihenfolge übertragen werden soll. Die Spalte, in die entsprechend dem ausgewählten Tabellenbereich eingeschrieben werden soll, wird mittels Betätigung der Tasten 9 bzw. 10 eingestellt. Bei der Prüfung gleicher Schaltungsteile können auf die oben erläuterte Weise bereits erstellte Prüfanweisungen schnell und einfach übernommen werden.

Ein Tabellenbereich zwischen zwei Zeilenpositionen kann ebenfalls kopiert werden. Hierfür sind in entsprechender Weise mit einem Zeichen die Spaltennummer, der Beginn und das Ende des zu kopierenden Bereichs zuerst anzugeben. Anschließend wird der Datenverarbeitungsanlage mittels Betätigung einer anderen Taste gemeldet, daß sich die folgenden eingegebenen Daten auf die Spaltennummer beziehen, ab der ein Bereich in aufsteigender Reihenfolge übertragen werden soll. Eine zusätzliche Taste 16 dient dazu, der Datenverarbeitsanlage 1 die Auswahl einer bestimmten Arbeitsweise zu melden. Nach Betätigung der Taste 16 fordert die Datenverarbeitungsanlage die Eingabe einer Adresse an, deren Pegel gemessen und als Sollpegel für die weitere Prüfung abgespeichert werden. Jeder übernommene Sollbereichspegel wird in der Tabelle angezeigt. Dadurch ist es möglich, die übernommenen Sollbereichspegel mit den laut Prüfplan bestimmten Sollbereichspegeln zu vergleichen. Der Vergleich erfordert weniger Zeit als die manuelle Eingabe der Sollbereichspegel über das Tastenfeld 4. Voraussetzung für diesen Vergleich ist, daß die für die Sollpegelerzeugung benutzte Schaltungsplatine fehlerfrei ist.

Die Anzahl der an den Anschlußstellen auftretenden Flankenwechsel der binären Signale kann mit einer entsprechenden Anweisung mit einem vorgegebenen Sollwert verglichen werden. Es können beispielsweise zwei Flankenwechsel durch ein Prüfsignal hervorgerufen werden. Mit einer Anweisung wird die Prüfung auf zwei Flankenwechsel festgelegt. Damit lassen sich undefinierte Signalbereiche ausblenden.

L i c e n t i a

Patent-Verwaltungs-GmbH

6000 Frankfurt/Main 70, Theodor-Stern-Kai 1

P 30 39 067.1
F 79/54
7.10.1981
Eb/pae

Verfahren zur Prüfung von gedrucken Schaltungsplatinen

Patentansprüche

1. Verfahren zur Prüfung von gedruckten Schaltungsplatinen mittels einer Datenverarbeitungsanlage, die mit einer die jeweilige Schaltungsplatine enthaltenden Teststation verbunden ist, der Testsignale in einer durch ein Prüfprogramm vorgegebenen Reihenfolge zugeführt werden und die mit einer Einrichtung zum Vergleich von Ausgangssignalen mit vorgegebenen Eingangssignalen verbunden ist, wobei diese Einrichtung von der Datenverarbeitungsanlage gesteuert wird und wobei den Anschlußstellen der jeweils zu prüfenden Schaltungsplatine und frei wählbaren Stellen auf der Schaltungsplatine Adressen zugeordnet werden,
d a d u r c h  g e k e n n z e i c h n e t ,
daß die Adressen der für die Prüfung ausgewählten Anschlußstellen jeweils über die Tastatur (4) eines Sichtgerätes (3) unter automatischer Weiterschaltung auf den benachbarten, einer Adresse zugeordneten freien Platz oder unter Anwahl eines freien Platzes in Zeilen einer festgelegten Tabelle eingegeben werden, die auf dem Schirm (6) des Sichtgerätes (3) angezeigt wird, daß nach der Adresseneingabe in weitere Zeilen der Tabelle jeweils Pegelbereiche durch digitale Zahlen nacheinander unter automatischer Weiterschaltung auf die Adressen zugeordneten Spalten oder beliebig wählbaren Spalten eingegeben werden und daß in spaltenmäßiger Zuordnung zu den Adressen nacheinander unter automatischer Weiterschaltung auf die jeweils benachbarte Spalte Prüfanweisungen eingegeben werden, die sich auf die Art der für eine Anschlußstelle ausgewählten Prüfung beziehen.

2. Verfahren nach Anspruch 1,
dadurch gekennzeichnet,
daß nach der Auswahl der Tabelle vor jeder Adressen-, Pegelbereichs- oder Prüfanweisungseingabe der Cursor des Sichtgerätes (3) unter die jeweilige für die Eingabe vorbereitete, auf dem Sichtgerät durch einen Tabellenplatz festgelegte Stelle springt.

3. Verfahren nach Ansprch 1 oder 2,
dadurch gekennzeichnet,
daß durch Eingabe von Sonderzeichen in Verbindung mit einer eine erste und eine zweite Zeile auswählenden Zahl der Bereich zwischen den Zeilen aus der Tabelle gelöscht wird.

4. Verfahren nach Anspruch 1 oder 2,
dadurch gekennzeichnet,
daß durch Eingabe von Sonderzeichen in Verbindung mit eine erste und eine zweite Spalte auswählenden Zahl der Bereich zwischen den Spalten aus der Tabelle gelöscht wird.

5. Verfahren nach Anspruch 1 oder einem der folgenden,
dadurch gekennzeichnet,
daß durch Eingabe weiterer Sonderzeichen in Verbindung mit einer ersten und einer zweiten Zeile sowie einer Zielzeile der zwischen der ersten und zweiten Zeile liegende Tabellenteil in den auf die Zielzeile folgenden Bereich übernommen wird.

6. Verfahren nach Anspruch 1 oder 2

d a d u r c h   g e k e n n z e i c h n e t ,

daß durch Eingabe zusätzlicher Sonderzeichen in Verbindung mit einer ersten und einer zweiten Spalte sowie einer Zielspalte der zwischen der ersten und zweiten Spalte liegende Tabellenteil in den auf die Zielspalte folgenden Bereich übernommen wird.

7. Verfahren nach Anspruch 1 oder einem der folgenden,

d a d u r c h   g e k e n n z e i c h n e t ,

daß durch eine zusätzliche Prüfanweisung in Verbindung mit einer Adresse der in einer ersten Betriebsart an dem der Adresse zugeordneten Anschluß vorhandene Pegel gemessen und als Sollpegel für eine zweite Betriebsart gespeichert wird, in der dieser Sollpegel mit dem Pegel am Anschluß verglichen wird.

8. Verfahren nach Anspruch 1 oder einem der folgenden,

d a d u r c h   g e k e n n z e i c h n e t ,

daß zusätzliche Prüfanweisungen für durch Anschlußadapter herstellbare Diagnoseanschlüsse vorgesehen sind, denen gesonderte Adressen zugeordnet sind.

9. Verfahren nach Anspruch 1 oder einem der folgenden,

d a d u r c h   g e k e n n z e i c h n e t ,

daß die Anzahl der an den Anschlußstellen auftretenden Flankenwechsel der binären Signale mit einem vorgegebenen Sollwert verglichen wird.

# FIG.1

# FIG.2

**Europäisches Patentamt**

**EUROPÄISCHER RECHERCHENBERICHT**

0050292

Nummer der Anmeldung

EP 81108221.3

## EINSCHLÄGIGE DOKUMENTE

| Kategorie | Kennzeichnung des Dokuments mit Angabe. soweit erforderlich, der maßgeblichen Teile | betrifft Anspruch |
|---|---|---|
| | DE - A - 1 949 898 (EBERHARD) <br>    * Seite 1, die beiden letzten <br>      Absätze * <br><br>      -- <br><br> DE - A1 - 2 347 495 (FRANCOTYP) <br>    * Fig. 1, Pos. 1,4,8,11,12 * <br><br>      -- <br><br> DE - A1 - 2 922 843 (HONEYWELL) <br>    * Gesamt * <br><br>      ---- | 1 <br><br><br><br><br> 1 <br><br><br><br><br> 1 |

**KLASSIFIKATION DER ANMELDUNG (Int. Cl.³)**

G 01 R 31/28
G 06 F 15/46

**RECHERCHIERTE SACHGEBIETE (Int. Cl.³)**

G 01 R 31/00
G 06 F 11/00
G 06 F 15/00
H 05 K 13/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 30-11-1981 | KUNZE |

EPA form 1503.1 06 78